# EUROPÄISCHE PATENTANMELDUNG

(11) **EP 1 863 330 A2**
(43) Veröffentlichungstag der Anmeldung: **05.12.2007**
(21) Anmeldenummer: 07106066.9
(22) Anmeldetag: 12.04.2007
(51) Int. Cl.: H05K 13/00

(54) **Verfahren zum Transportieren von Substraten in Bestückautomaten und Transportsystem**

(30) Priorität: 30.05.2006 DE 102006025170
(71) Anmelder: SIEMENS AKTIENGESELLSCHAFT, 80333 München (DE)
(72) Erfinder: Mehdianpour, Mohammad, 81829, München (DE); Rauch, Robert, 82327, Tutzing (DE)

(57) **Zusammenfassung**

Zum Transport von Substraten (2, 16, 20, 21) in einen Bestückautomaten ist erfindungsgemäß eine bewegliche Speichereinrichtung (11) vorgesehen, die sowohl in Transportrichtung (4) also auch in der Höhe beweglich ist. Durch einen an der beweglichen Speichereinrichtung (11) in Transportrichtung (4) vorgelagerten Substrat-Sensor (12) wird erkannt, wenn von einer Transporteinrichtung (5) ein Substrat (2) bis in die Nähe der beweglichen Speichereinrichtung (11) transportiert wurde. Anschließend wird die bewegliche Speichereinrichtung (11) abgesenkt, unter das Substrat (2) bewegt und angehoben. Damit wird das Substrat (2) von der Transporteinrichtung (5) getrennt und in dieser Speicherposition gehalten, bis ein zweites Substrat (16) vor der beweglichen Speichereinrichtung (11) anhält und ebenso von dieser aufgenommen wird. Auf diese Weise können mehrere Substrate (2, 16, 20, 21) auf der beweglichen Speichereinrichtung (11) gesammelt werden, die dann anschließend gemeinsam von der beweglichen Speichereinrichtung (11) in den Bestückbereich des Bestückautomaten transportiert werden können.

## Beschreibung

Die Erfindung bezieht sich auf ein Verfahren zum Transportieren von Substraten in einem Bestückautomaten und ein Transportsystem.

In Bestückautomaten mit feststehendem Substrat, in der Regel Leiterplatten, werden Substrate mit Bauelementen bestückt, in dem die Bauelemente mittels eines Bestückkopfes aus Zuführeinheiten entnommen, der Bestückkopf über das in einem Bestückbereich des Bestückautomaten fixierte Substrat bewegt und die Bauelemente lagerichtig auf dem Substrat abgesetzt werden. Gegenüber Bestückautomaten mit beweglichem Substrat und feststehendem Bestückkopf weist dieses Verfahren den Vorteil auf, dass die bereits auf dem Substrat bestückten Bauelemente nicht mehr so leicht von ihren Positionen wegrutschen können.
Das Transportsystem für die Substrate innerhalb eines Bestückautomaten sieht dabei in der Regel mehrere Transportbänder als Endlosbänder vor, die parallel zueinander und in Transportrichtung erstreckt angeordnet sind, und auf deren jeweiligen Oberflächen die Substrate aus einem Magazin in den Bestückbereich und nach dem Bestückvorgang aus dem Bestückbereich zu einem weiteren Bearbeitungsautomaten, bspw. einem weiteren Bestückautomaten oder einem Ofen, transportiert werden. Häufig ist das Transportsystem dreigeteilt in ein so genanntes Eingabeband für den Transport zum Bestückbereich, ein Band im Bestückbereich und ein so genanntes Ausgabeband für den Transport weg vom Bestückbereich. Die einzelnen Transportbänder werden dabei so angesteuert, dass die Substrate von einem Transportband an das nächste Transportband in Transportrichtung übergeben werden.

Im Bestückbereich werden die Substrate mittels einer Klemmeinrichtung fixiert, damit während des Bestückvorgangs keine Bewegung der Substrate auftreten kann.

Der beschriebene Aufbau der bekannten Transportsysteme führt dazu, dass in der Regel nur ein Substrat auf jedem Transportband transportiert werden, bzw. in der Klemmeinrichtung geklemmt werden kann.

Zum Stoppen der Substrate sind in der Regel mechanische Stopper im Transportweg vorgesehen, gegen welche die Substrate durch die bewegten Transportbänder gefahren werden. Die Substratgröße variiert dabei je nach Anwendungsfall, Leiterplatten für Mobiltelefone oder Speichermodule beispielsweise sind sehr viel kleiner als Leiterplatten für Computer. Um den Bestückbereich eines Bestückautomaten auch bei kleinen Leiterplatten optimal auszunutzen, sind Verfahren bekannt, bei denen zunächst ein erstes Substrat durch das Eingabeband gegen den mechanischen Stopper gefahren wird und anschließend ein zweites Substrat (ggf. nachfolgend weitere Substrate) gegen das am mechanischen Stopper gestoppte erste Substrat. Die zwei (ggf. mehreren) aneinander geschobenen Substrate werden dann gemeinsam in den Bestückbereich transportiert und gemeinsam von der Klemmeinrichtung geklemmt und gemeinsam bestückt. Der ortsfest angeordnete Stopper muss dabei je nach Substratgröße vor den einzelnen Bestückaufträgen von Hand justiert werden. Außerdem ist nicht sichergestellt, dass die zusammengeschobenen Substrate auch während des Transports in den Bestückbereich zusammenbleiben.

In einem weiteren bekannten Verfahren werden die gemeinsam zu bestückenden Substrate bereits im Bestückbereich an einem mechanischen Stopper gesammelt. Da während der Sammlung im Bestückbereich der Bestückautomat nicht bestücken kann, führt dieses Verfahren allerding zu unerwünscht hohen Nebenzeiten.

Es ist daher die Aufgabe der Erfindung ein Verfahren zum Transportieren von Substraten in einem Bestückautomaten sowie ein Transportsystem anzugeben, welches mit geringen Nebenzeiten auskommt und durch den Verzicht auf mechanische Stopper einen geringeren Rüstaufwand verursacht.

Die Aufgabe wird erfindungsgemäß gelöst durch ein Verfahren mit den Merkmalen des Patentanspruchs 1 und ein Transportsystem mit den Merkmalen des Patentanspruchs 10.

Beim erfindungsgemäßen Verfahren werden zwei Substrate, die gemeinsam bestückt werden sollen, zunächst in eine erste, respektive zweite Speicherposition transportiert und erst anschließend gemeinsam in den Bestückbereich transportiert. Dadurch werden die Substrate zunächst außerhalb des Bestückbereichs gesammelt, so dass in anderen Bereichen des Bestückautomaten weitere Funktionen durchgeführt werden können.

In vorteilhafter Weise befinden sich die Speicherpositionen gemäß Anspruch 2 entfernt von der Transporteinrichtung, so dass während des Transports nachfolgender Substrate die bereits in den Speicherpositionen befindlichen Substrate nicht mehr verschoben werden können.

In der bevorzugten Ausgestaltung des Verfahrens nach Anspruch 3 werden weitere Substrate ebenfalls gesammelt und anschließend gemeinsam in den Bestückbereich transportiert, damit mit unterschiedlich großen Substraten der Bestückbereich mit der jeweils auf die Größe der Substrate abgestimmten Anzahl der Substrate gefüllt werden kann. Eine genaue Anpassung der Anzahl der Substrate an den Bestückbereich ist gemäß Anspruch 4 vorgesehen.

Vorteilhaft gestaltet sich das Verfahren gemäß Anspruch 5, bei dem während des Sammelns der Substrate im Bestückbereich weitere Substrate bestückt werden. Dadurch werden minimale Nebenzeiten erreicht.

Eine weitere Einsparung von Nebenzeiten ergibt sich gemäß Anspruch 6 dadurch, dass beim Transport der gesammelten Substrate in den Bestückbereich gleichzeitig die vorher im Bestückbereich bestückten Substraten aus dem Bestückbereich heraustransportiert werden.

In der bevorzugten Ausgestaltung des Verfahrens gemäß Anspruch 7 ist eine bewegliche Speichereinrichtung vorgesehen, auf deren Oberfläche die Substrate gesammelt werden und anschließend in den Bestückbereich transportiert werden. Durch die Kombination von Speicherfunktion und Transportfunktion lassen sich die Nebenzeiten weiter reduzieren.

Wird die bewegliche Speichereinrichtung gemäß Anspruch 8 so verwendet, dass von der Transporteinrichtung transportierte Substrate an einer Vorderkante der beweglichen Speichereinrichtung gestoppt werden, so kann auf zusätzliche, jeweils pro Bestückauftrag separat zu justierende mechanische Stopper verzichtet werden.
Die beschriebene Bewegung der Speichereinrichtung lässt sich technisch einfach realisieren.

In vorteilhafter einfacher Weise ist das Transportsystem gemäß Anspruch 11 aus zwei beabstandet angeordneten Hubblechen ausgebildet, die in Transportrichtung und senkrecht zur Transportebene bewegbar sind.

In der bevorzugten Ausgestaltung gemäß Anspruch 12 ist eine Klemmvorrichtung im Bestückautomaten vorgesehen, die mit der beweglichen Speichereinrichtung derartig zusammenwirkt, dass gleichzeitig mehrere Substrate von der beweglichen Speichereinrichtung an die Klemmvorrichtung übergeben werden können. Dadurch lässt sich der Wechsel der Substrate schnell erreichen.

In technisch einfacher Weise ist die Klemmvorrichtung gemäß Anspruch 13 mit zwei beweglichen Krallen ausgestattet, die wechselweise die Klemmung der Substrate unterstützen und die Übergabe an die bewegliche Speichereinrichtung ermöglichen.

Werden die Substrate von der beweglichen Speichereinrichtung gesammelt und gemeinsam an die Klemmvorrichtung übergeben, so ist in vorteilhafter Weise vorgesehen, dass die bewegliche Speichereinrichtung etwa so lang wie der Bestückbereich ausgebildet ist, damit alle gemeinsam zu bestückenden Substrate auf der beweglichen Speichereinrichtung Platz haben.

Ist vorgesehen, dass die bestückten Substrate gleichzeitig aus dem Bestückbereich entfernt werden, wenn die gesammelten Substrate in den Bestückbereich transportiert werden, dann ist in der bevorzugten Ausgestaltung des Transportsystems gemäß Anspruch 15 vorgesehen, dass die bewegliche Speichereinrichtung in etwa doppelt so lang wie der Bestückbereich ausgebildet ist.

Gemäß Anspruch 16 ist eine Ausgabe-Transporteinrichtung vorgesehen, an welche die bestückten Substrate von der beweglichen Speichereinrichtung übergeben werden.

Mithilfe eines an der beweglichen Speichereinrichtung in Transportrichtung vorgelagert angeordneten Sensors lässt sich gemäß Anspruch 17 in einfacher Weise überprüfen, ob ein Substrat vor der beweglichen Speichereinrichtung angekommen ist, um von dieser aufgenommen zu werden.

Ein zusätzlicher mechanischer Stopper zum Anhalten der Substrate lässt sich gemäß Anspruch 18 in einer bevorzugten Ausgestaltung des Transportsystems dadurch einsparen, dass die in Transportrichtung vordere Kante der beweglichen Speichereinrichtung als Stopper für die Substrate ausgebildet ist.

Die Erfindung wird im Folgenden mittels eines Ausführungsbeispiels anhand der Figuren der Zeichnung näher erläutert. Dabei zeigen
Fig.1 einen schematischen Querschnitt durch ein erfindungsgemäßes Transportsystem in einem ersten Verfahrensschritt,
Fig.2 einen schematischen Querschnitt durch ein erfindungsgemäßes Transportsystem in einem zweiten Verfahrensschritt,
Fig.3 einen schematischen Querschnitt durch ein erfindungsgemäßes Transportsystem in einem dritten Verfahrensschritt,
Fig.4 einen schematischen Querschnitt durch ein erfindungsgemäßes Transportsystem in einem vierten Verfahrensschritt,
Fig.5 einen schematischen Querschnitt durch ein erfindungsgemäßes Transportsystem in einem fünften Verfahrensschritt,
Fig.6 einen schematischen Querschnitt durch ein erfindungsgemäßes Transportsystem in einem sechsten Verfahrensschritt,
Fig.7 einen schematischen Querschnitt durch ein erfindungsgemäßes Transportsystem in einem siebten Verfahrensschritt,
Fig.8 einen schematischen Querschnitt durch ein erfindungsgemäßes Transportsystem in einem achten Verfahrensschritt,
Fig.9 einen schematischen Querschnitt durch ein erfindungsgemäßes Transportsystem in einem neunten Verfahrensschritt,
Fig.10 einen schematischen Querschnitt durch ein erfindungsgemäßes Transportsystem in einem zehnten Verfahrensschritt,
Fig.11 einen schematischen Querschnitt durch ein erfindungsgemäßes Transportsystem in einem elften Verfahrensschritt,
Fig.12 einen schematischen Querschnitt durch ein erfindungsgemäßes Transportsystem in einem zwölften Verfahrensschritt,
Fig.13 einen schematischen Querschnitt durch ein erfindungsgemäßes Transportsystem in einem dreizehnten Verfahrensschritt,
Fig.14 einen schematischen Querschnitt durch ein erfindungsgemäßes Transportsystem in einem vierzehnten Verfahrensschritt,
Fig.15 einen schematischen Querschnitt durch ein erfindungsgemäßes Transportsystem in einem fünfzehnten Verfahrensschritt,
Fig.16 a einen schematischen Querschnitt durch ein erfindungsgemäßes Transportsystem entlang einer Linie A-A' nach Figur 1 mit durch die bewegliche Speichereinrichtung transportiertem Substrat,

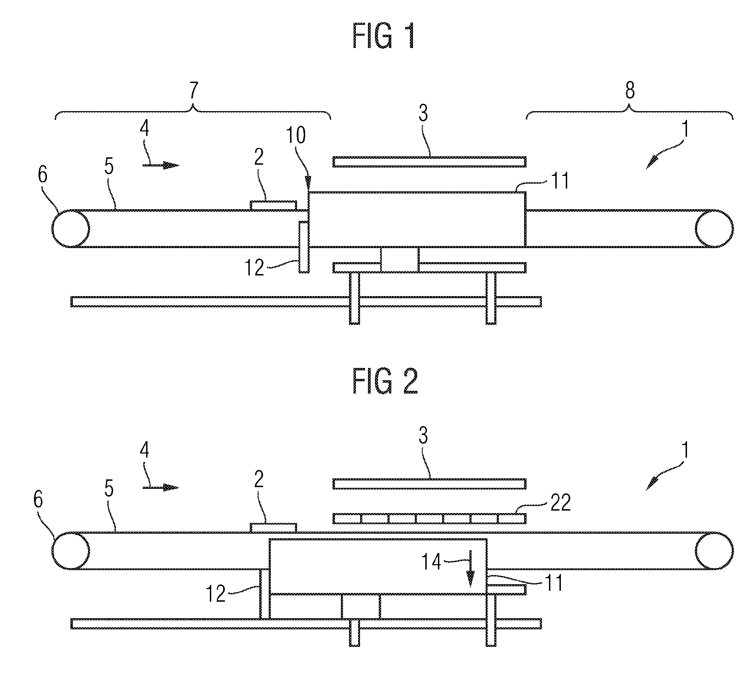

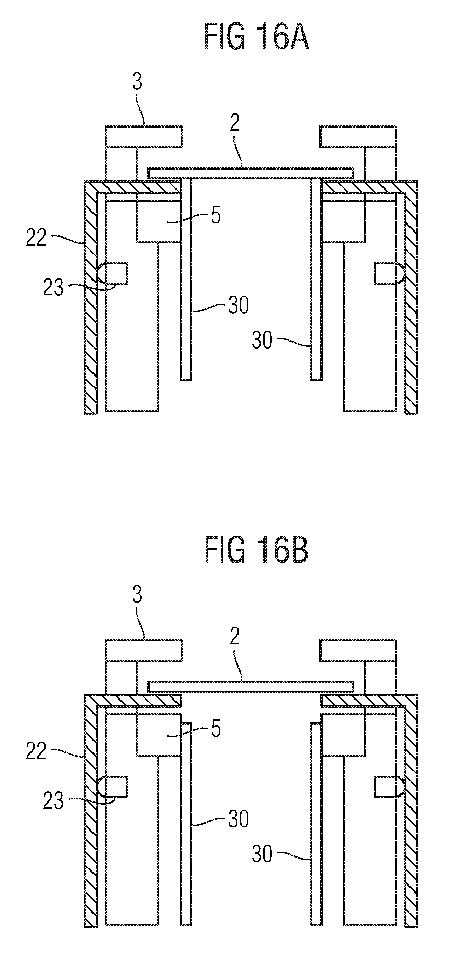

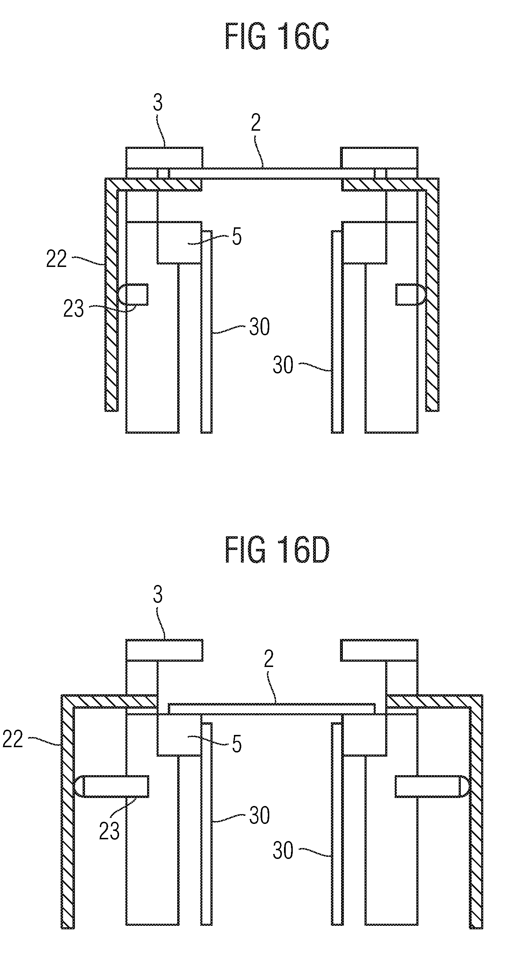

Fig.16 b einen schematischen Querschnitt durch ein erfindungsgemäßes Transportsystem entlang einer Linie A-A' nach Figur 1 mit auf den Krallen der Klemmeinrichtung abgelegtem Substrat,
Fig.16 c einen schematischen Querschnitt durch ein erfindungsgemäßes Transportsystem entlang einer Linie A-A' nach Figur 1 mit geklemmtem Substrat, und
Fig.16 d einen schematischen Querschnitt durch ein erfindungsgemäßes Transportsystem entlang einer Linie A-A' nach Figur 1 mit entklemmten und auf der Transporteinrichtung liegendem Substrat (nach der Bestückung).

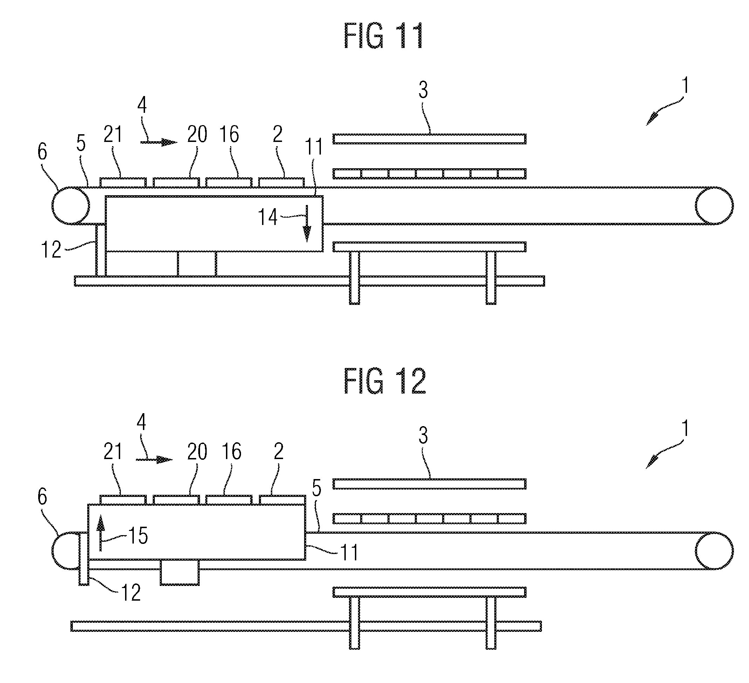

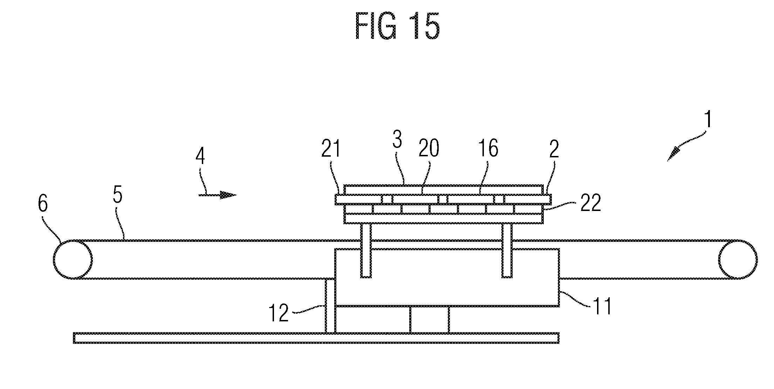

In den Figuren 1 bis 15 ist exemplarisch ein Verfahrensablauf des erfindungsgemäßen Verfahrens dargestellt. Die Bezugszeichen werden dabei bei ihrem ersten Auftreten erläutert.

In Fig.1 ist ein Transportsystem 1 dargestellt, welches ein erstes Substrat 2 in den Bestückbereich eines Bestückautomaten transportiert, welcher in etwa die räumliche Ausdehnung der dargestellten oberen Klemmbacke 3 einer Klemmvorrichtung aufweist. Der Transport der Substrate in der Transportrichtung 4 erfolgt dabei mit einer Transporteinrichtung 5, hier dargestellt als über zwei Rollen 6 angetriebenes Endlosband. In der Regel sind auf beiden Seiten des Transportweges jeweils separate Endlosbänder angeordnet, die sich aufeinander abgestimmt gleichmäßig bewegen. Obwohl in den Figuren die Transporteinrichtung 5 sowohl für die Anlieferung der Substrate 1 in einem Eingabebereich 7 vor dem Bestückbereich und in einem Ausgabebereich 8 nach dem Bestückbereich ausgebildet ist, funktioniert das erfindungsgemäße Verfahren und das erfindungsgemäße Transportsystem auch mit für den Eingabebereich 7 und den Ausgabebereich 8 getrennten Transporteinrichtungen, beispielsweise Endlosbändern. Im Bestückbereich ist keine solche Transporteinrichtung erforderlich.

In einem ersten Verfahrenschritt wird das erste Substrat 2 mit der Transporteinrichtung 5 transportiert, bis ein der beweglichen Speichereinrichtung 11 in Transportrichtung 4 vorgelagerter Sensor 12, beispielsweise eine Lichtschranke, das erste Substrat 2 erkennt und die Transporteinrichtung 5 stoppt. Die bewegliche Speichereinrichtung 11 kann dabei aus zwei ca. 0,5 mm dicken Hubblechen 30 bestehen (siehe auch Figur 16a), die entlang von Seitenwangen (nicht dargestellt) in der Transportrichtung 4 verfahrbar sind.

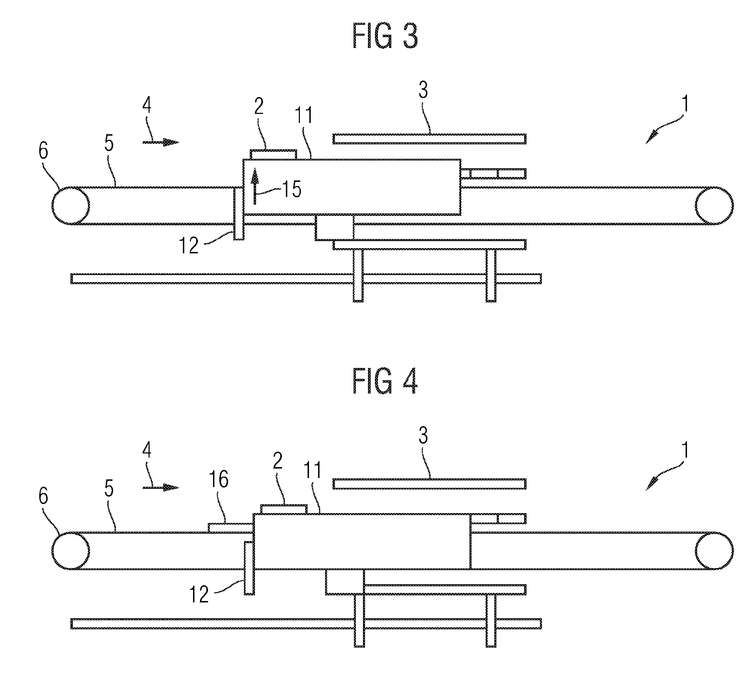

Im nächsten - in Figur 2 dargestellten - Schritt wird die bewegliche Speichereinrichtung 11 von einer oberen Position in eine untere Position abgesenkt (Pfeil 14) und entgegen der Transportrichtung 4 unter das erste Substrat 2 bewegt. Befindet sich die bewegliche Speichereinrichtung 11 unterhalb des ersten Substrats 2, wird diese in die obere Position bewegt (Pfeil 15) und hebt damit das erste Substrat 2 von der Transporteinrichtung 5 ab in eine erste Speicherposition, wie es in Figur 3 dargestellt ist.

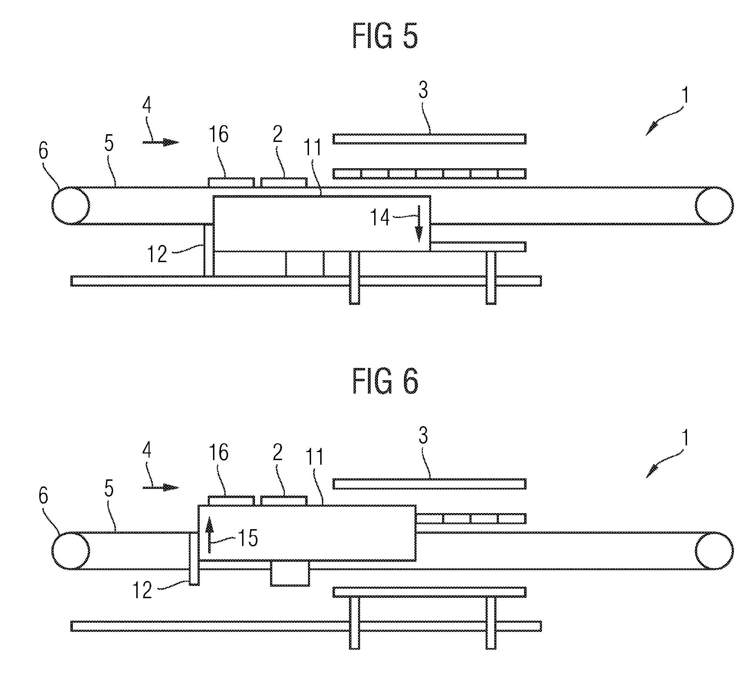

Anschließend wird, wie in Figur 4 gezeigt, ein zweites Substrat 16 von der Transporteinrichtung 5 bis gegen die Vorderkante 10 der beweglichen Speichereinrichtung 11 gefahren, die Transporteinrichtung durch das Erkennen des zweiten Substrats 16 durch den Sensor 12 gestoppt, die bewegliche Speichereinrichtung 11 in die untere Position und gegen die Transportrichtung 4 unter das zweite Substrat bewegt (siehe Figur 5), wobei das erste Substrat 2 wieder auf der Transporteinrichtung 5 aufliegt und anschließend in die obere Position bewegt (Figur 6), so dass beide Substrate 2,16 von der Transporteinrichtung 5 abgehoben in ihrer jeweiligen Speicherposition gebracht werden.

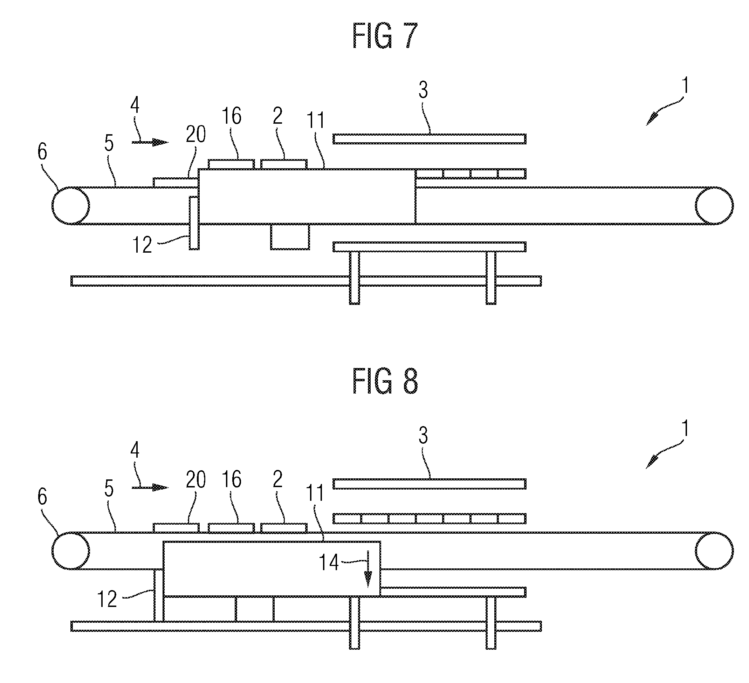

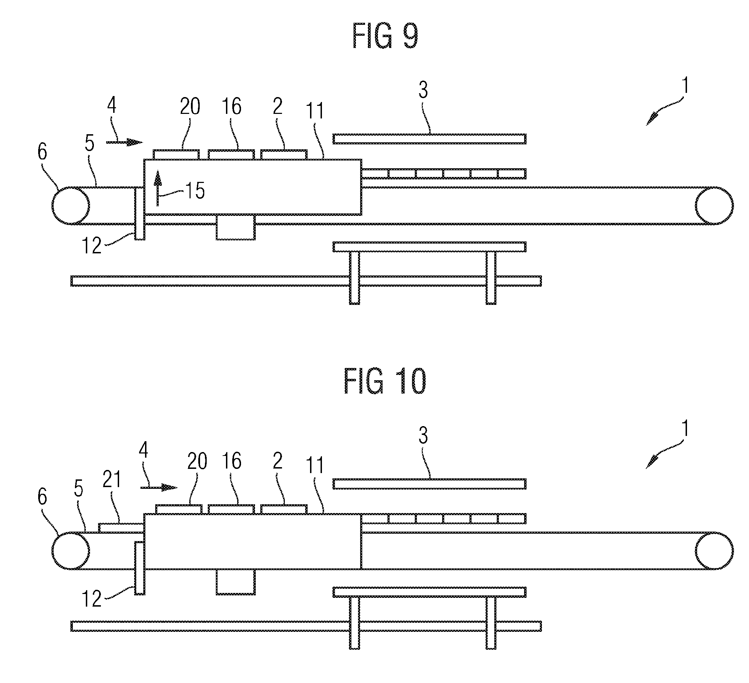

Dieser Ablauf kann sich nun für eine Anzahl von Substraten wiederholen, in den Figuren 7-9 ist der Ablauf für ein drittes Substrat 20 und in den Figuren 10-12 für ein viertes Substrat 21 dargestellt, bis die bewegliche Speichereinrichtung 11 mit so vielen Substraten gefüllt ist, wie gleichzeitig im Bestückbereich des Bestückautomaten bestückt werden können.

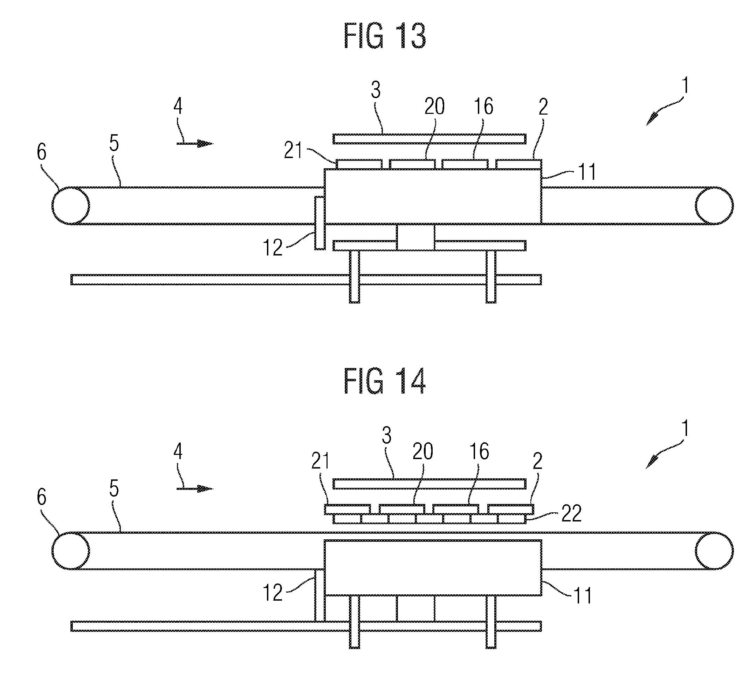

Anschließend werden, wie in Figur 13 dargestellt, durch eine Bewegung der beweglichen Speichereinrichtung 11 das erste bis vierte Substrat 2, 16, 20, 21 gemeinsam in den Bestückbereich transportiert. Während dieser Bewegung könnte eine doppelt so lange bewegliche Speichereinrichtung 11 auch zeitgleich bereits bestückte Substrate aus dem Bestückbereich in Transportrichtung in den Ausgabebereich bewegen (nicht dargestellt).

Durch eine Bewegung der beweglichen Speichereinrichtung 11 in die untere Position werden die Substrate 2, 16, 20, 21 auf Krallen 22 der Klemmvorrichtung abgesetzt, die im folgenden Schritt durch einen Stempel 23 nach oben gegen die obere Klemmbacke 3 bewegt werden und damit die Substrate 2, 16, 20, 21 zwischen den Krallen 22 und der oberen Klemmbacke 3 fixiert werden und bestückt werden können. Während der Bestückung dieser Substrate kann die bewegliche Speichereinrichtung 11 in der beschriebenen Art und Weise weitere Substrate für den nächsten Bestückzyklus einsammeln.

Die Funktion der Krallen ist in den Figuren 16a bis 16d näher erläutert, die einen Querschnitt entlang der Linie A-A' der Figur 1 darstellen. In Figur 16a befinden sich die Krallen 22 in einer inneren Position, das dargestellte Substrat (bspw. das erste Substrat 2) wird von der beweglichen Speichereinrichtung 11 gehalten und ist gerade in den Bestückbereich transportiert worden.

In Figur 16b ist dargestellt, wie die bewegliche Speichereinrichtung 11 in die untere Position bewegt wurde und das erste Substrat 2 dadurch auf den Krallen 22 aufliegt.

Im nächsten Schritt (Figur 16c) werden die Krallen 22 nach oben bewegt, so dass das erste Substrat 2 zwischen den Krallen 22 und der oberen Klemmbacke 3 für den Bestückvorgang fixiert ist.

Nach dem Bestückvorgang werden die Krallen 22 nach unten bewegt, wie in Figur 16d dargestellt, und durch bspw. pneumatische Zylinder 23 in eine äußere Position, so dass das erste Substrat 2 auf den Endlosbändern der Transporteinrichtung 5 aufliegt und aus dem Bestückbereich hinaustransportiert werden kann.

Das erfindungsgemäße Verfahren und Transportsystem ist für alle Substratformen geeignet und es ermöglicht das Zusammenführen von Einzelschaltungen zu größeren "Bestücknutzen". Je kürzer die Substrate in Transportrichtung sind, umso mehr Substrate können zusammengefasst werden, wodurch extrem kurze Transportzeiten möglich sind. Durch die Verwendung des Sensors 12 sind variable Stopperpositionen möglich. Die Auf- und Abwärtsbewegung sowie Bewegung in und entgegen der Transportrichtung 4 durch die bewegliche Speichereinrichtung 11 ermöglicht hohe Transportgeschwindigkeiten wegen des näherungsweise sinoiden Bewegungsablaufes.

## Patentansprüche

1. Verfahren zum Transportieren von Substraten (2, 16, 20, 21) in einem Bestückautomaten bei dem
ein erstes zu bestückendes Substrat (2) in den Bestückautomaten transportiert und an einer ersten Position gestoppt wird,
das erste Substrat (2) in eine erste Speicherposition gebracht wird,
ein zweites zu bestückendes Substrat (16) in den Bestückautomaten transportiert und an einer zweiten Position gestoppt wird,
das zweite Substrat (16) in eine zweite Speicherposition gebracht wird,
das erste (2) und das zweite Substrat (16) gemeinsam von der ersten und zweiten Speicherposition aus in den Bestückbereich transportiert werden.

2. Verfahren zum Transportieren von Substraten (2, 16, 20, 21) in einem Bestückautomaten nach Anspruch 1, **dadurch gekennzeichnet, dass**
die zu bestückenden Substrate (2, 16, 20, 21) jeweils von einer Transporteinrichtung (5) in den Bestückautomaten transportiert werden und durch das Bringen in die jeweilige Speicherposition von der Transporteinrichtung (5) getrennt werden.

3. Verfahren zum Transportieren von Substraten (2, 16, 20, 21) in einem Bestückautomaten nach einem der Ansprüche 1 oder 2,
**dadurch gekennzeichnet, dass**
weitere zu bestückende Substrate (20,21) in den Bestückautomaten transportiert und an einer jeweiligen Position gestoppt werden,
dass die weiteren Substrate (20,21) in weitere Speicherpositionen gebracht werden und
dass die weiteren Substrate (20, 21) gemeinsam mit dem ersten (2) und dem zweiten (16) Substrat von den jeweiligen Speicherpositionen in den Bestückbereich transportiert werden.

4. Verfahren zum Transportieren von Substraten (2, 16, 20, 21) nach Anspruch 3, **dadurch gekennzeichnet, dass** so viele Substrate (2, 16, 20, 21) in den Bestückautomaten transportiert, in jeweilige Speicherpositionen gebracht und gemeinsam in den Bestückbereich transportiert werden, wie im Bestückbereich des Bestückautomaten gleichzeitig bestückt werden können.

5. Verfahren zum Transportieren von Substraten (2, 16, 20, 21) in einem Bestückautomaten nach einem der Ansprüche 1 bis 4, **dadurch gekennzeichnet, dass** parallel zum Transport der Substrate (2, 16, 20, 21) in den Bestückautomaten und dem Bringen in die jeweiligen Speicherpositionen zusätzliche Substrate im Bestückbereich des Bestückautomaten bestückt werden.

6. Verfahren zum Transportieren von Substraten (2, 16, 20, 21) nach Anspruch 5, **dadurch gekennzeichnet, dass** beim Transport der zu bestückenden Bauelemente von den Speicherpositionen in die Bestückposition gleichzeitig die bestückten zusätzlichen Substrate aus dem Bestückbereich heraustransportiert werden.

7. Verfahren zum Transportieren von Substraten (2, 16, 20, 21) nach einem der Ansprüche 1 bis 6, **dadurch gekennzeichnet, dass**
zum Bringen in jeweilige Speicherpositionen und zum gemeinsamen Transport in die Bestückposition eine bewegliche Speichereinrichtung (11) vorgesehen ist, auf deren Oberseite die einzelnen Substrate (2, 16, 20, 21) gespeichert werden.

8. Verfahren zum Transportieren von Substraten (2, 16, 20, 21) nach Anspruch 7,
**dadurch gekennzeichnet, dass**
die bewegliche Speichereinrichtung (11) in eine obere und eine untere Position bewegbar ist,
die bewegliche Speichereinrichtung (11) vor oder während des Transportierens des ersten Substrats (2) in die obere Position gebracht wird, die so gewählt ist, dass das erste Substrat (2) an einer in Transportrichtung (4) vorderen Kante (10) der beweglichen Speichereinrichtung (11) gestoppt wird,
nach dem Stoppen des ersten Substrats (2) die Transporteinrichtung (5) angehalten wird,
die bewegliche Speichereinrichtung (11) in die untere Position gebracht wird, in der eine Oberkante der beweglichen Speichereinrichtung (11) unterhalb des ersten Substrates (2) liegt,
die bewegliche Speichereinrichtung (11) entgegen der Transportrichtung (4) unter das erste Substrat (2) bewegt wird,
die bewegliche Speichereinrichtung (11) in die obere Position bewegt wird, wobei das erste Substrat (2) auf der Oberkante der beweglichen Speichereinrichtung (11) aufliegt und von der Transporteinrichtung (5) abgehoben wird,
und für das zweite (16) und ggf. folgende Substrate (20, 21) entsprechend verfahren wird.

9. Verfahren zum Transportieren von Substraten (2, 16, 20, 21) nach einem der Ansprüche 7 oder 8, **dadurch gekennzeichnet, dass** im Bestückbereich eine Klemmvorrichtung (3, 22) zum Klemmen der Substrate (2, 16, 20, 21) während des Bestückvorgangs vorgesehen ist.

10. Transportsystem (1) in einem Bestückautomaten
mit einer Transporteinrichtung (5) zum Transportieren von Substraten (2, 16, 20, 21) in einer Transportrichtung (4) in den Bestückautomaten,
mit einer in Transportrichtung (4) im Wesentlichen nachgelagerten beweglichen Speichereinrichtung (11), die in der Transportrichtung (4) der Substrate (2, 16, 20, 21) beweglich ist,
wobei die Transporteinrichtung (5) und die bewegliche Speichereinrichtung (11) derartig zusammenwirken, dass mehrere von der Transporteinrichtung (5) nacheinander transportierte Substrate (2, 16, 20, 21) an die bewegliche Speichereinrichtung (11) übergeben werden können,

11. Transportsystem (1) nach Anspruch 10,
**dadurch gekennzeichnet, dass**
die Transporteinrichtung (5) aus zwei in einer Transportebene parallel angeordneten Transportriemen ausgebildet ist und die bewegliche Speichereinrichtung (11) von zwei beabstandet angeordneten parallelen Hubblechen (30) gebildet ist, die in Transportrichtung (4) und senkrecht zur Transportebene bewegbar sind.

12. Transportsystem (1) nach einem der Ansprüche 10 oder 11,
**dadurch gekennzeichnet, dass**
in einem Bestückbereich des Bestückautomaten eine Klemmvorrichtung (3,22) vorgesehen ist, die mit der beweglichen Speichereinrichtung (11) derartig zusammenwirkt, dass von der beweglichen Speichereinrichtung (11) transportierte Substrate (2, 16, 20, 21) gemeinsam an die Klemmvorrichtung (3,22) übergeben werden können.

13. Transportsystem (1) nach Anspruch 12,
**dadurch gekennzeichnet, dass**
die Klemmvorrichtung (3,22) zwei parallel zur Transportebene und senkrecht zur Transportrichtung bewegliche Krallen (22) zur wechselweisen Klemmung der Substrate im Bestückbereich und Übergabe an die bewegliche Speichereinrichtung (11) aufweist.

14. Transportsystem (1) nach einem der Ansprüche 10 bis 13,
**dadurch gekennzeichnet, dass**
die bewegliche Speichereinrichtung (11) in Transportrichtung (4) etwa so lang wie der Bestückbereich ausgebildet ist.

15. Transportsystem (1) nach einem der Ansprüche 10 bis 13,
**dadurch gekennzeichnet, dass**
die bewegliche Speichereinrichtung (11) in Transportrichtung (4) in etwa doppelt so lang wie der Bestückbereich ausgebildet ist.

16. Transportsystem (1) nach einem der Ansprüche 10 bis 15,
**dadurch gekennzeichnet, dass**
eine Ausgabe-Transporteinrichtung vorgesehen ist, an welche im Bestückbereich bestückte Substrate durch die bewegliche Speichereinrichtung (11) übergeben werden können.

17. Transportsystem (1) nach einem der Ansprüche 10 bis 16,
**dadurch gekennzeichnet, dass**
ein Substrat-Sensor (12) an der beweglichen Speichereinrichtung (11) in Transportrichtung (4) vorgelagert angeordnet ist.

18. Transportsystem (1) nach einem der Ansprüche 10 bis 17,
**dadurch gekennzeichnet, dass**
die in Transportrichtung (4) vordere Kante der beweglichen Speichereinrichtung (11) als Stopper für die Substrate (2, 16, 20, 21) ausgebildet ist.
